# EUROPÄISCHE PATENTSCHRIFT

(11) **EP 3 891 481 B1**
(45) Veröffentlichungstag und Bekanntmachung des Hinweises auf die Patenterteilung: **09.08.2023**
(21) Anmeldenummer: 19813304.3
(22) Anmeldetag: 29.11.2019
(51) Int. Cl.: G01K 1/14, G01K 1/16, H05B 45/18

(54) **TEMPERATUR- UND UMGEBUNGSLICHTMESSUNG BEI SELBSTLEUCHTENDEN ANZEIGETECHNOLOGIEN IN AUTOMOBILANWENDUNGEN**
TEMPERATURE MEASUREMENT AND AMBIENT LIGHT MEASUREMENT IN THE CASE OF SELF-LUMINOUS DISPLAY TECHNOLOGIES IN AUTOMOTIVE APPLICATIONS
MESURE DE TEMPÉRATURE ET DE LUMIÈRE AMBIANTE DANS DES TECHNOLOGIES D'AFFICHAGE AUTOLUMINESCENTES DANS DES APPLICATIONS AUTOMOBILES

(30) Priorität: 07.12.2018 DE 102018221239; 21.03.2019 DE 102019203870
(43) Veröffentlichungstag der Anmeldung: 13.10.2021
(73) Patentinhaber: Continental Automotive Technologies GmbH, 30165 Hannover (DE)
(72) Erfinder: BÄTHIS, Jürgen, 60488 Frankfurt am Main (DE); WEBER, Markus, 60488 Frankfurt am Main (DE); LAHR, Torsten, 60488 Frankfurt am Main (DE); LOTZ, Rüdiger, 60488 Frankfurt am Main (DE)
(74) Vertreter: Continental Corporation
(86) Internationale Anmeldenummer: PCT/EP2019/083107
(87) Internationale Veröffentlichungsnummer: WO 2020/114911

(56) Entgegenhaltungen:
- EP-A2- 1 467 408
- EP-B1- 1 467 408
- US-A1- 2005 248 264
- US-A1- 2016 098 957
- US-B1- 6 774 883

## Beschreibung

Die vorliegende Erfindung betrifft die Temperatur- und Umgebungslichtmessung bei Technologien für selbstleuchtende Displays basierend beispielsweise organischen Leuchtdioden, oft mit OLED abgekürzt, Mikroleuchtdioden, oft mit µLED abgekürzt, Quantenpunktleuchtdioden, oft mit QLED abgekürzt, aber auch andere auf Leuchtdioden oder anderen selbstleuchtenden Anzeigeelementen beruhende Displaytechnologien.

Aus der US 9,881,547 B2 ist eine Anzeigeeinrichtung mit selbstleuchtenden Anzeigeelementen bekannt, die auf einem Panel angeordnet sind, welches auf seiner Rückseite, die der zur Anzeige dienenden Leuchtfläche gegenüberliegt, mit einem Wärmeverteilelement versehen ist, auf dessen der Rückseite abgewandten Seite zumindest ein Temperatursensor angeordnet ist. Dabei ist der Temperatursensor fest in das Panel eingebaut, in dem auch die selbstleuchtenden Anzeigeelemente angeordnet sind. Dies ist aufwendig herzustellen, und läßt sich daher im Produktionsprozeß nur schwierig an geänderte Anforderungen anpassen. Eine demgegenüber verbesserte Lösung zur Temperaturmessung, die möglichst auch noch eine Umgebungslichtmessung mit einschließt, ist erwünscht.

Aus der US 2016/0098957 A1 ist ein OLED-Display und ein Verfahren zu dessen Ansteuerung bekannt. Auch US 2005/0248264 A1 und EP 1 467 408 A2 betreffen OLED-Displays.

Eine Anzeigeeinrichtung gemäß der Erfindung ist im unabhängigen Anspruch 1 angegeben. Erfindungsgemäß weist das Wärmeverteilelement zumindest eine Öffnung auf, hinter der ein Lichtsensor angeordnet ist, wobei der Lichtsensor und der Temperatursensor auf einem gemeinsamen Träger angeordnet sind. Das Anordnen auf einem gemeinsamen Träger ermöglicht eine definierte Positionierung der beiden Sensoren relativ zueinander. Es ermöglicht ebenfalls eine elektrische Kontaktierung der Sensoren. Das Anordnen der Sensoren nicht im Panel sondern außen an dessen Rückseite ermöglicht es, ein kostengünstiges Panel zu verwenden welches ohne eingebaute Sensoren hergestellt wird. Erfindungsgemäß werden die Sensoren, die je nach vorgesehenem Einsatzzweck und den entsprechenden Randbedingungen unterschiedlich zu positionieren sind, an der jeweils geeigneten Stelle angeordnet. Das Anbringen einer Öffnung im Wärmeverteilelement ist ohne großen Aufwand durchführbar in dem entweder ein entsprechend vorgesehenes Wärmeverteilelement auf das Panel aufgebracht wird, oder die entsprechende Stelle eines bereits am Panel angeordneten Wärmeverteilelement entfernt wird. Die vorgeschlagene Lösung ist somit kostengünstig und dennoch ist die entsprechende Produktlinie durch Änderung der Art wie der Temperatursensor bzw. der Umgebungslicht Sensor angeordnet ist auf unterschiedliche Gegebenheiten anpaßbar.

Eine erfindungsgemäße Variante sieht vor, daß der gemeinsame Träger eine flexible Leiterplatte ist. Dies hat den Vorteil, daß eine flexible Leiterplatte dünn und somit sowohl für Wärme als auch für Licht durchlässig ist. Die Sensoren sind vorteilhafterweise auf der dem Wärmeverteilelement abgewandten Seite der flexiblen Leiterplatte angeordnet, sodaß deren geometrische Abmessungen / unterschiedliche Höhen etc. das Wärmeverteilelement nicht beeinträchtigen, sondern die glatte, unbestückte Seite der flexiblen Leiterplatte mit der ebenfalls glatten Oberfläche des Wärmeverteilelement in Kontakt steht.

Vorteilhafterweise weist die flexible Leiterplatte einen ersten Kontaktierungsbereich und einen zweiten Kontaktierungsbereich auf, sowie einen Sensorbereich. Dabei sind der Sensorbereich und der zweite Kontaktierungsbereich mit dem ersten Kontaktierungsbereich einstückig ausgeführt. Der Sensorbereich und der zweite Kontaktierungsbereich sind aber voneinander durch eine Ausnehmung getrennt. In der einfachsten Ausführung ist die Ausnehmung eine, beispielsweise durch einen mechanischen Einschnitt erzeugte Trennung. Gemäß einer anderen Ausführung weisen Sensorbereich und zweiter Kontaktierungsbereich einen größeren Abstand zueinander auf, beispielsweise erzeugt durch ausschneiden eines flächigen Bereichs zwischen Sensorbereich und zweitem Kontaktierungsbereich. Dies hat den Vorteil, eine ohnehin zum Kontaktieren der Anzeigeeinrichtung mit einer Steuerungseinheit erforderliche flexible Leiterplatte durch Anbringen eines Sensorarms / Sensorbereichs ohne großen Aufwand um Temperatur- und Lichtmessung erweitert auszuführen.

Gemäß einer anderen erfindungsgemäßen Variante ist der gemeinsame Träger eine mechanisch stabile Leiterplatte. Eine mechanisch stabile, also unflexible Leiterplatte, ermöglicht es vorteilhafterweise, eine Auswerteelektronik oder Ähnliches direkt bei den Sensoren anzuordnen. Vorteilhafterweise ist die stabile Leiterplatte vom Wärmeverteilelement beabstandet angeordnet. Dies ermöglicht einen Wärmeabtransport durch den Spalt zwischen stabiler Leiterplatte und Wärmeverteilelement. Auch tritt keine thermische oder mechanische Beeinflussung des Wärmeverteilelements durch die stabile Leiterplatte oder auf ihr angeordnete Bauelemente auf.

Vorteilhafterweise ist die stabile Leiterplatte mit einer Öffnung versehen, auf deren dem Wärmeverteilelement abgewandten Seite der Lichtsensor angeordnet ist. Dies hat den Vorteil, daß durch die Anordnung des Lichtsensors auf der dem Wärmeverteilelement abgewandten Seite keine mechanische Beeinträchtigung dessen durch die Sensoren auftritt. Durch die Öffnung ist sichergestellt, daß der Lichtsensor das durch das Panel und die Öffnung im Wärmeverteilelement hindurchfallende Licht empfangen und detektieren kann. Bei Anordnung eines Spalts zwischen Wärmeverteilelement und stabiler Leiterplatte tritt vorteilhafterweise keine Beschränkung des zwischen diesen befindlichen Zwischenraums auf und damit auch keine Beeinträchtigung eine durch Luftzug oder Ähnliches erfolgenden Wärmeabfuhr.

Vorzugsweise ist die Leiterplatte mittels eines Verbindungselements am Wärmeverteilelement angeordnet. Dies erspart Bauraum. Weiterhin ist es damit ermöglicht, eines oder mehrere aus Ansteuerelektronik für das Panel, Auswerteelektronik für Temperatursensor und/oder Lichtsensor, und Verarbeitungselektronik direkt am Panel anzuordnen und als Komplettteil vorzumontieren und einzubauen. Als Verbindungselement ist beispielsweise eine beidseitige Klebefolie vorgesehen, entsprechende Klebebänder, ausgehärtete Klebemasse, oder auch eine andere Verbindung wie Rastverbindung oder Klemmverbindung.

Ist das Verbindungselement ein Polsterelement, so hat dies den Vorteil, daß Erschütterungen gedämpft werden, unterschiedliche thermische Ausdehnungen kompensiert werden, und das Wärmeverteilelement vor direktem Kontakt mit der Leiterplatte geschützt wird. Auch umgekehrt wird somit die Leiterplatte von unerwünschtem Kontakt mit dem Wärmeverteilelement geschützt, welches bei Kontakt mit deren Oberfläche dort aufgebrachte Leiterbahnen oder andere Elemente beeinträchtigen kann. Besteht das Polsterelement aus einer geschäumten oder porigen Masse, ist zudem eine Wärmeisolierung zwischen Wärmeverteilelement und Leiterplatte gewährleistet. Dies vermindert zum einen Wärmeeintrag von der Leiterplatte auf das Wärmeverteilelement und somit Verfälschungen der Temperaturmessung, und zum anderen eine unerwünschte Erwärmung der Leiterplatte.

Vorzugsweise weist das Verbindungselement zumindest eine Ausnehmung auf, die sich im Bereich zumindest eines der Sensoren, Temperatursensor und Lichtsensor, befindet. Dies gewährleistet, daß der Temperatursensor nahe am Wärmeverteilelementangeordnet ist, und/oder der Lichtsensor nahe am Panel. In der Ausnehmung ist der jeweilige Sensor gegen unerwünschte Umgebungseinflüsse abgeschirmt. Den Lichtsensor erreicht kein Streulicht, das nicht vom Panel her kommt. Auf den Temperatursensor erfolgt keine Wärmeübertragung, die nicht vom Panel her kommt. In der Ausnehmung befindet sich gemäß einer bevorzugten Variante Luft oder ein anderes geeignetes Fluid als Wärmeleitelement.

Vorzugsweise ist vorgesehen, daß der Temperatursensor mittels eines Wärmeleitelements thermisch an das Wärmeverteilelement gekoppelt ist. Als Wärmeleitelement ist beispielsweise eine wärmeleitende Paste vorgesehen, die zwischen Leiterplatte und Wärmeverteilelement angeordnet ist, eine wärmeleitende Paste, die in eine Ausnehmung der Leiterplatte angeordnet ist, in der Leiterplatte befindliche thermische Vias, oder eine Kombination daraus oder auch mit anderen, dem Fachmann bekannten Wärmeleitelementen. Ein Vorteil dieser Variante liegt darin, daß trotz beabstandeter Anordnung des Temperatursensors, gegebenenfalls auf der abgewandten Seite der stabilen Leiterplatte, dennoch eine gute Wärmeleitung und somit eine recht genaue Messung der Temperatur ermöglicht ist.

Ein Problembereich bei Anzeigeeinrichtungen ist der Kontrast bei hellem Umgebungslicht. Typischerweise wird hier ein Lichtsensor neben der Anzeigeeinrichtung oder deren Panel angebracht. OLED-Anzeigeeinrichtungen im Consumerbereich benötigen im allgemeinen keinen externen Temperatursensor. Im Automobilbereich ist ein zusätzlicher Temperatursensor allerdings notwendig, da hier aufgrund der hohen möglicherweise auftretenden Temperaturen und der starken möglichen Temperaturschwankungen ein spezifischer Algorithmus zur Alterungskompensation zur Anwendung kommt, der eine genaue Temperatursensierung erfordert. Die Integration eines Sensors auf der Systemseite außerhalb des Display-Anzeigebereiches erfaßt die tatsächliche Temperatur nur indirekt und ungenau. Ohne präzise Temperaturinformationen kann keine optimale Alterungskompensation erfolgen. Eine Integration eines oder mehrerer Temperatursensoren in das Panel 1 ist wiederum sehr aufwendig und unflexibel.

Erfindungsgemäß erfolgt eine Helligkeitsmessung durch den aktiven Anzeigebereich des selbstleuchtenden Display-Panels, wie z.B. OLED, hindurch. Hierzu wird die vorhandene optische Transmission des Display-Panels ausgenutzt. Die Temperaturmessung erfolgt in direktem thermischen Kontakt mit der Rückseite des Display Panels.

Weitere Vorteile und Varianten der Erfindung sind auch der folgenden Beschreibung von Ausführungsbeispielen anhand der Figuren zu entnehmen. Dabei zeigen:
- Fig. 1: erste erfindungsgemäße Ausführungsform
- Fig.2: zweite erfindungsgemäße Ausführungsform
- Fig.3-5: weitere erfindungsgemäße Ausführungsformen

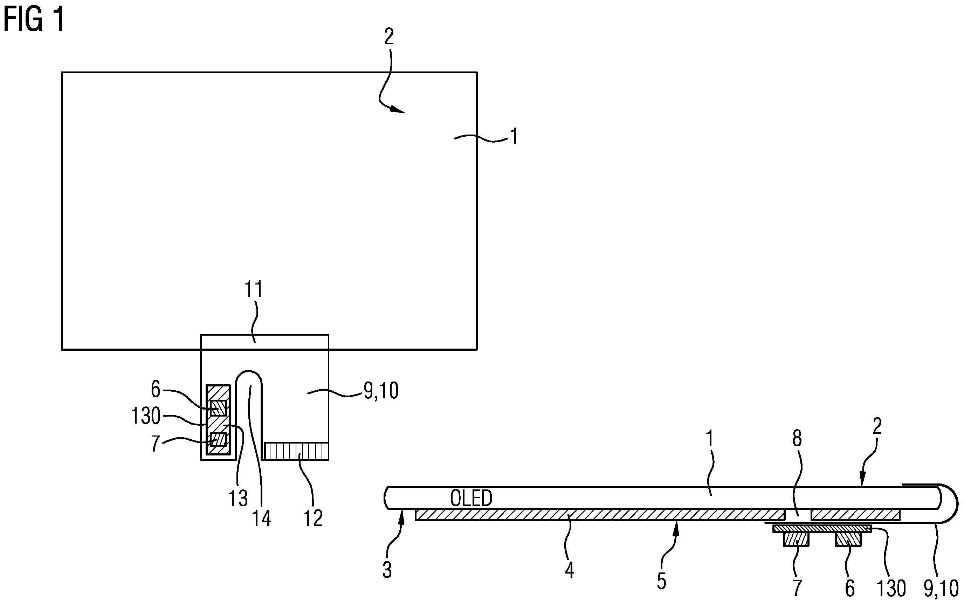

Fig.1 zeigt eine erste erfindungsgemäße Ausführungsform in Draufsicht und in einer Schnittdarstellung. Man erkennt das Panel 1, in dem die selbstleuchtenden Anzeigeelemente, beispielsweise organischen Leuchtdioden, OLED, angeordnet sind. Es weist eine zur Anzeige dienende Leuchtfläche 2 auf. Auf der der Leuchtfläche 2 gegenüberliegenden Rückseite 3 des Panels 1 ist ein Wärmeverteilelement 4 angeordnet. Auf der der Rückseite 3 abgewandten Seite 5 des Wärmeverteilelements 4 sind ein Temperatursensor 6 und ein Lichtsensor 7 angeordnet. Der Lichtsensor 7 wird oft auch als Fotosensor bezeichnet. Das Wärmeverteilelement 4 weist eine Öffnung 8 auf, hinter der der Lichtsensor 7 angeordnet ist. Der Lichtsensor 7 und der Temperatursensor 6 sind auf einem gemeinsamen Träger 9 angeordnet. In der dargestellten Ausführungsform ist der gemeinsame Träger 9 eine flexible Leiterplatte 10. Diese weist einen ersten Kontaktierungsbereich 11 und einen zweiten Kontaktierungsbereich 12 auf. Der erste Kontaktierungsbereich 11 dient zur Kontaktierung der Ansteuerungsleitungen und gegebenenfalls von anderen elektrischen Leitungen des Panels 1. Hier nicht dargestellte Daten- und Versorgungsleitungen verlaufen vom ersten Kontaktierungsbereich 11 zum zweiten Kontaktierungsbereich 12. Die flexible Leiterplatte 10 weist weiterhin einen Sensorbereich 13 auf, auf dem der Temperatursensor 6 und der Lichtsensor 7 angeordnet sind. Der Sensorbereich 13 und der zweite Kontaktierungsbereich 12 sind einstückig mit dem ersten Kontaktierungsbereich 11 ausgeführt, voneinander aber durch eine Ausnehmung 14 getrennt. Dies ist in der Draufsicht auf der linken Seite der Figur 1 gut erkennbar, in der die flexible Leiterplatte 10 in noch nicht montierten Zustand gezeigt ist. Zur Montage wird der Sensorbereich 13 nach unten umgebogen und, in der Schnittdarstellung rechts unten sichtbar, von unten an das Wärmeverteilelement 4 angelegt. Dabei wird der Lichtsensor 7 zur Öffnung 8 ausgerichtet.

Die flexible Leiterplatte 10 ist im Sensorbereich 13 mit einem Verstärkungselement 130 versehen, welches hier in Draufsicht schraffiert dargestellt ist. Es dient dazu, die flexible Leiterplatte 10 im Bereich um die Sensoren 6,7 herum zu verstärken. Somit wird einer Beschädigung der flexiblen Leiterplatte 10 vorgebeugt. Des weiteren wird eine definierte relative Ausrichtung von Temperatursensor 6 und Lichtsensor 7 zueinander gewährleistet. Sie liegen dadurch in einer Ebene. Das Verstärkungselement 130 besteht beispielsweise aus einem auf die flexible Leiterplatte 10 aufgebrachten steifen, flächigen Element, aus einer erhabenen Bedruckung, die gegebenenfalls eine stabilisierende Struktur aufweist, oder ähnlichem.

Somit erstreckt sich vom Panel 1 aus neben den Daten- und Versorgungsleitungen über den Hauptstrang der flexiblen Leiterplatte 10 ein Abgang über einen zweiten Finger, den Sensorbereich 13, mit bestückten Sensoren 6,7 für Temperatur und Umgebungshelligkeit. Die Leitungsführung auf der flexiblen Leiterplatte 10 ist entsprechend so gestaltet, daß diese über den Hauptstrang der flexiblen Leiterplatte 10 mit einer hier nicht dargestellten Systemleiterplatte kontaktiert wird.

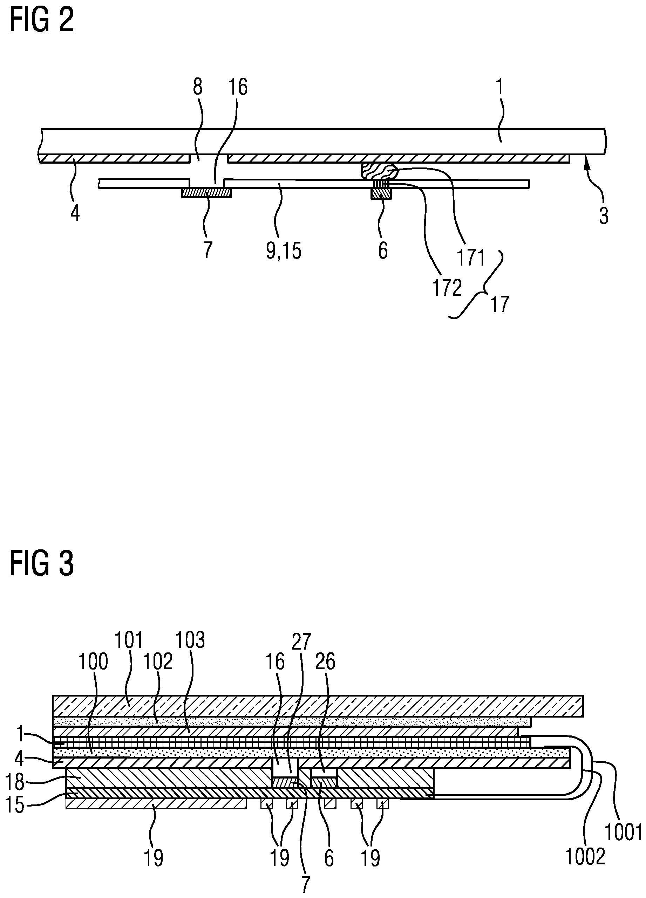

Fig.2 zeigt eine zweite erfindungsgemäße Ausführungsform in Schnittdarstellung. Gleiche oder gleichwirkende Elemente sind mit den gleichen Bezugszeichen wie zuvor beschrieben bezeichnet und hauptsächlich dann erneut beschrieben, wenn und insofern sie sich von den zuvor beschriebenen unterscheiden. Man erkennt das Panel 1 und das auf seiner Rückseite 3 angeordnete Wärmeverteilelement 4 mit seiner Öffnung 8. Der Temperatursensor 6 und der Lichtsensor 7 sind in diesem Ausführungsbeispiel auf einer mechanisch stabilen Leiterplatte 15 als Träger 9 angeordnet. Die Leiterplatte 15 ist beispielsweise die Systemleiterplatte. Sie weist eine Öffnung 16 auf, auf deren dem Wärmeverteilelement 4 abgewandten Seite der Lichtsensor 7 angeordnet ist. Der Temperatursensor 6 ist mittels zweier Wärmeleitelemente 17 thermisch an das Wärmeverteilelement 4 gekoppelt. Zwischen Wärmeverteilelement 4 und stabiler Leiterplatte 15 ist eine wärmeleitende Paste 171 angeordnet, die den Spalt zwischen Leiterplatte 15 und Wärmeverteilelement 4 thermisch überbrückt. Weiterhin sind in die Leiterplatte 15 thermische Vias 172 eingebracht. Die thermischen Vias 172 bestehen beispielsweise aus mehreren nebeneinanderliegenden dünnen Bohrungen durch die Leiterplatte 15, welche mit einer metallischen Füllung versehen sind. Die metallische Füllung bewirkt eine gute Wärmeleitung. Die Bohrungen in der Leiterplatte werden wie andere Bohrungen in der Leiterplatte standardmäßig hergestellt und stellen somit keinen erhöhten Aufwand dar. Auch die metallische Füllung wird wie die übliche metallische Kontaktierung auf der Leiterplatte angebracht und erfordert somit ebenfalls keinen erhöhten Produktionsaufwand.

Die Leiterplatte 15 wird somit direkt hinter dem Panel 1 des OLED-Displays angebracht. Die beiden Sensoren 6,7 werden zusammen mit anderen, hier nicht dargestellten Bauteilen auf der dem Panel 1 abgewandten Seite aufgebracht. Eine Fotosensor, dessen Lichtempfindliche Seite zur Öffnung 16 hin ausgerichtet ist, empfängt Licht durch die Öffnung 16, die beispielsweise als eine Bohrung in der Leiterplatte ausgelegt ist. Der Temperatursensor ist über thermische Vias 172 und Wärmeleitfähiges Material 171 an das Panel 1 angebunden. Bei Anbringen mehrerer Lichtsensoren 7 kann die Helligkeit auch lokal an unterschiedlichen Lichteinfall, beispielsweise aufgrund Abschattung auftretend, angepaßt werden.

Fig. 3 zeigt eine weitere erfindungsgemäße Ausführungsform, bei der eine Leiterplatte 15 mittels eines Verbindungselements 18 mit dem Wärmeverteilelement 4 verbunden ist. An das Wärmeverteilelement 4 schließt sich das Panel 1 an, welches an seiner Unterseite ein Feld 100 aus Ansteuerelementen aufweist, oft auch als "Low Temperature Poly Silicon" oder LTPS-Schicht bezeichnet. Darüber befindet sich ein Deckglas 101, welches mittels einer optisch klaren Klebeschicht 102 an einem an der Oberseite des Panels 1 befindlichen Polarisator 103 befestigt ist.

Auf dem Panel 1 befinden sich Berührungs- oder Annäherungssensoren, die hier nicht gezeigt sind, welcher aber mittels einer flexiblen Leiterplatte 1001 mit der Leiterplatte 15 verbunden sind. Auch das Feld 100 aus Ansteuerelementen ist mittels einer flexiblen Leiterplatte 1002 mit der Leiterplatte 15 verbunden. An der Unterseite der Leiterplatte 15 erkennt man Elektronikelemente 19, wie Widerstände, Kondensatoren, Transistoren, integrierte Bausteine und ähnliches, die hier nicht näher beschrieben sind. An der Oberseite der Leiterplatte 15 sind der Temperatursensor 6 und der Lichtsensor 7 angeordnet. Man erkennt, daß sich der Temperatursensor 6 in einer Ausnehmung 26 befindet und der Lichtsensor 7 in einer Ausnehmung 27. Die Ausnehmung 27 geht in die Öffnung 16 des Wärmeverteilelements 4 über. Somit ist es ermöglicht, daß Streulicht, vom Panel 1 kommend, den Lichtsensor 7 ungehindert erreicht. Vorzugsweise wird dazu die Panel-Transmission im nahen Infrarotbereich, vorzugsweise im Bereich von 800-900 nm, detektiert.

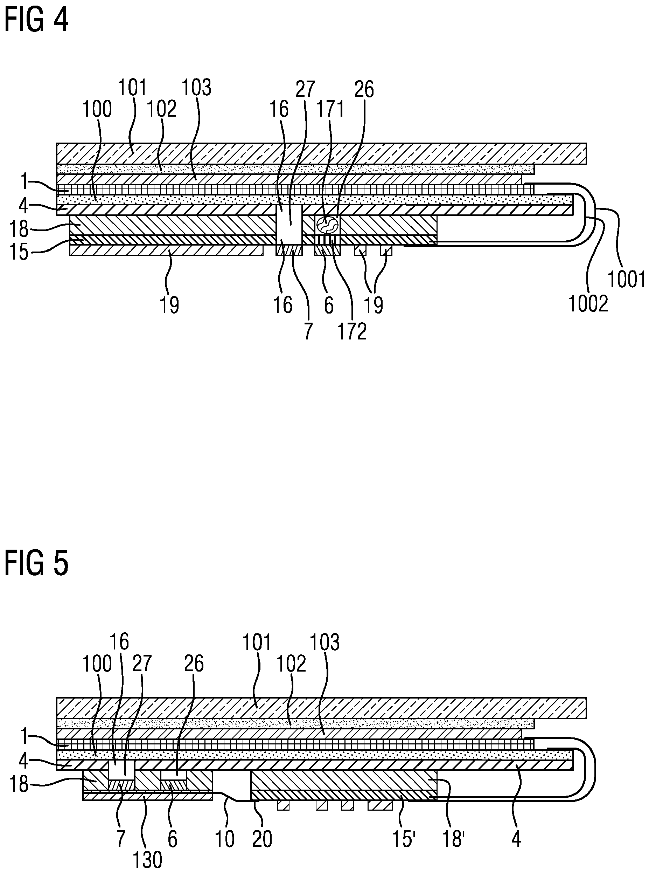

Fig.4 zeigt eine weitere erfindungsgemäße Variante mit einer Leiterplatte 15, die mittels eines Verbindungselements 18 am Panel 1 befestigt ist. Gleiche Elemente wie zuvor beschrieben werden mit gleichen Bezugszeichen versehen und nicht notwendigerweise erneut beschrieben. Man erkennt, daß hier der Temperatursensor 6 und der Lichtsensor 7 auf der Unterseite der Leiterplatte 15 angeordnet sind. Dazu weist die Leiterplatte 15 eine Öffnung 16 auf, die sich an die Ausnehmung 27 und die Öffnung 16 anschließt, sodaß auch hier der Lichtsensor 7 Sichtkontakt zum Panel 1 hat. Der Temperatursensor 6 ist mittels thermischer Vias 172 mit der Ausnehmung 26 verbunden, in der hier eine wärmeleitende Paste 171 angeordnet ist.

Fig.5 zeigt eine weitere erfindungsgemäße Ausführungsform. Hier ist eine Leiterplatte 15' vorgesehen, die zur Ansteuerung des Panels 1 erforderliche Schaltkreise enthält. Der Temperatursensor 6 und der Lichtsensor 7 sind auf einer separaten flexiblen Leiterplatte 10 angeordnet, welche mit einem Verstärkungselement 130 versehen ist. Das Verstärkungselement 130 ist hier auf der Unterseite der flexiblen Leiterplatte 10 dargestellt, eine Anordnung auf deren Oberseite liegt aber ebenso im Rahmen der Erfindung. Die Leiterplatte 15' ist über das Verbindungselement 18' mit dem Wärmeverteilelement 4 verbunden, während die flexible Leiterplatte 10 mittels eines Verbindungselements 18 mit dem Wärmeverteilelement 4 verbunden ist. Auch hier sind wieder die Öffnung 16 und die Ausnehmung 27 zum Lichtsensor 7 hin ausgerichtet angeordnet. Der Temperatursensor 6 befindet sich in einer Ausnehmung 26. Die flexible Leiterplatte 10 hat hier den Vorteil, daß eine optimale Ausrichtung von Öffnung 16 und Ausnehmung 27 erreicht werden kann, ohne daß die gesamte Leiterplatte 15' verschoben werden müßte. Lediglich die flexibel mit ihr verbundene flexible Leiterplatte 10 ist entsprechend auszurichten. Ein weiterer Vorteil besteht darin, daß die Leiterplatte 15' und die flexible Leiterplatte 10 unabhängig voneinander entworfen und hergestellt werden können, wodurch Anpassungen der Funktion der Leiterplatte 15' und derjenigen der flexiblen Leiterplatte 10 unabhängig voneinander vorgenommen werden können. Dies erhöht die Flexibilität und Anpassungsfähigkeit an sich ändernde Gegebenheiten, beispielsweise wenn andere oder bessere Panels zur Verfügung stehen, die eine geänderte Ansteuerung ohne Änderung der Sensoren, oder die einen geänderten Temperatursensor oder Lichtsensor erfordern, ohne eine Änderung der Ansteuerung. Gemäß einer vorteilhaften Variante der Erfindung stellt das an der flexiblen Leiterplatte 10 befindliche Verbindungselement 18 eine dem Verstärkungselement 130 entsprechende Funktionalität zur Verfügung. Ein separates Verstärkungselement 130 erübrigt sich somit.

Die Ausführungsformen der Figuren 3-5 weisen ein Leiterplatte 15,15' auf, die mittels eines Polsterbandes, das beidseitig Klebeflächen aufweist, direkt auf die Rückseite des Panels 1 geklebt werden. Der Temperatursensor 6 und der Lichtsensor 7 werden entweder direkt auf der Leiterplatte 15 angeordnet, die die zur Ansteuerung des Panels 1 erforderlichen Schaltkreise enthält. Oder sie werden an einer flexiblen Leiterplatte 10 angeordnet und über einen separaten Stecker 20 mit der Leiterplatte 15 verbunden. Der Lichtsensor 7 schaut somit durch das Panel 1 und nutzt die bei OLED im nahen Infrarotbereich liegende Panel-Transmission aus. Dies ist zum Erreichen der gewünschten Funktion ausreichend. Der Temperatursensor 6 ist entweder in Richtung Panel 1 auf der Leiterplatte 15 angeordnet oder über thermische Vias 172 an diese angebunden.

Die erfindungsgemäß vorgeschlagenen Varianten weisen unter anderem folgende Vorteile auf: Es ist eine einfache Integration von Helligkeits- und Temperatursensoren auf der Rückseite von OLED Displays oder allgemein selbstleuchtenden Displays ermöglicht. Solche Displays erzeugen Wärme, die abgeführt wird, um Überhitzung und vorzeitige Alterung zu vermeiden. Eine präzise Temperaturmessung nahe am alternden Bauteil ist ermöglicht. Damit einhergehend ist auch eine verbesserte Alterungskompensation ermöglicht. Auch ein optimierter Kontrast bei Umgebungslicht ist ermöglicht. Dies ist auch bei allen Displays in mobilen Anwendungen, wie z.B. Displays in der Luftfahrt, Displays in Zügen, Displays in der Medizintechnik anwendbar.

## Patentansprüche

1. Anzeigeeinrichtung mit einem Panel (1), in dem selbstleuchtende Anzeigeelemente angeordnet sind, welches Panel (1) auf seiner der zur Anzeige dienenden Leuchtfläche (2) gegenüberliegenden Rückseite (3) mit einem Wärmeverteilelement (4) versehen ist, auf dessen der Rückseite (3) abgewandten Seite (5) zumindest ein Temperatursensor (6) angeordnet ist, **dadurch gekennzeichnet, dass** das Wärmeverteilelement (4) zumindest eine Öffnung (8) aufweist, hinter der ein Lichtsensor (7) angeordnet ist, wobei der Lichtsensor (7) und der Temperatursensor (6) auf einem gemeinsamen Träger (9) angeordnet sind, welcher mit der dem Panel (1) abgewandten Seite (5) des Wärmeleitelements (4) verbunden ist.

2. Anzeigeeinrichtung gemäß Anspruch 1, wobei der gemeinsame Träger (9) eine flexible Leiterplatte (10) ist.

3. Anzeigeeinrichtung gemäß Anspruch 2, wobei die flexible Leiterplatte (10) einen ersten Kontaktierungsbereich (11) und einen zweiten Kontaktierungsbereich (12) und einen Sensorbereich (13) aufweist, wobei der Sensorbereich (13) und der zweite Kontaktierungsbereich (12) mit dem ersten Kontaktierungsbereich (11) einstückig ausgeführt sind, sowie der Sensorbereich (13) und der zweite Kontaktierungsbereich (12) voneinander durch eine Ausnehmung (14) getrennt sind.

4. Anzeigeeinrichtung gemäß Anspruch 1, wobei der gemeinsame Träger (9) eine mechanisch stabile Leiterplatte (15) ist.

5. Anzeigeeinrichtung gemäß Anspruch 4, wobei die stabile Leiterplatte (15) eine Öffnung (16) aufweist, auf deren dem Wärmeverteilelement (4) abgewandten Seite der Lichtsensor (7) angeordnet ist.

6. Anzeigeeinrichtung gemäß Anspruch 4 oder Anspruch 5, wobei die Anzeigeeinrichtung ein Wärmeleitelement umfasst, und der Temperatursensor (6) mittels des Wärmeleitelements (17) thermisch an das Wärmeverteilelement (4) gekoppelt ist.

7. Anzeigeeinrichtung gemäß einem der vorhergehenden Ansprüche, wobei die Anzeigeeinrichtung weiterhin ein Verbindungselement (18, 18') aufweist, und die Leiterplatte (15) mittels diesem am Wärmeverteilelement (4) angeordnet ist.

8. Anzeigeeinrichtung gemäß Anspruch 7, wobei das Verbindungselement (18,18') ein Polsterelement ist.

9. Anzeigeeinrichtung gemäß Anspruch 7 oder 8, wobei das Verbindungselement (18) zumindest eine Ausnehmung (26,27) aufweist, die sich im Bereich zumindest eines aus Temperatursensor (6) und Lichtsensor (7) befindet.

## Claims

1. Display device with a panel (1) in which self-luminous display elements are arranged, which panel (1) is provided, on its rear side (3) opposite the light-emitting surface (2) used for display, with a heat distribution element (4), on the side (5) of which facing away from the rear side (3) at least one temperature sensor (6) is arranged, **characterized in that** the heat distribution element (4) has at least one opening (8) behind which a light sensor (7) is arranged, wherein the light sensor (7) and the temperature sensor (6) are arranged on a common carrier (9) which is connected to the side (5) of the heat-distribution element (4) facing away from the panel (1).

2. Display device according to Claim 1, wherein the common carrier (9) is a flexible printed circuit board (10).

3. Display device according to Claim 2, wherein the flexible printed circuit board (10) has a first contact region (11) and a second contact region (12) and a sensor region (13), wherein the sensor region (13) and the second contact region (12) are embodied in one piece with the first contact region (11) and the sensor region (13) and the second contact region (12) are separated from one another by a recess (14).

4. Display device according to Claim 1, wherein the common carrier (9) is a mechanically stable printed circuit board (15).

5. Display device according to Claim 4, wherein the stable printed circuit board (15) has an opening (16) on the side of which facing away from the heat distribution element (4) the light sensor (7) is arranged.

6. Display device according to Claim 4 or Claim 5, wherein the display device comprises a heat-conducting element and the temperature sensor (6) is thermally coupled to the heat distribution element (4) by means of the heat-conducting element (17).

7. Display device according to any of the preceding claims, wherein the display device furthermore has a connection element (18, 18') and the printed circuit board (15) is arranged at the heat distribution element (4) by means of the connection element (18, 18').

8. Display device according to Claim 7, wherein the connection element (18, 18') is a cushion element.

9. Display device according to Claim 7 or 8, wherein the connection element (18) has at least one recess (26, 27), which is located in the region of at least one of the temperature sensor (6) and light sensor (7).

## Revendications

1. Dispositif d'affichage comportant un panneau (1) dans lequel sont disposés des éléments d'affichage autoluminescents, lequel panneau (1) est pourvu, sur son côté arrière (3) opposé à la surface luminescente (2) servant à l'affichage, d'un élément de répartition de chaleur (4) dont le côté (5) opposé au côté arrière (3) comporte au moins un capteur de température (6), **caractérisé en ce que** l'élément de répartition de chaleur (4) présente au moins une ouverture (8) derrière laquelle est disposé un capteur de lumière (7), le capteur de lumière (7) et le capteur de température (6) étant disposés sur un support commun (9) qui est relié au côté (5) de l'élément conducteur de chaleur (4) qui est opposé au panneau (1).

2. Dispositif d'affichage selon la revendication 1, dans lequel le support commun (9) est une carte de circuit imprimé flexible (10).

3. Dispositif d'affichage selon la revendication 2, dans lequel la carte de circuit imprimé flexible (10) présente une première zone de contact (11) et une deuxième zone de contact (12) et une zone de capteur (13), la zone de capteur (13) et la deuxième zone de contact (12) étant réalisées d'un seul tenant avec la première zone de contact (11), et la zone de capteur (13) et la deuxième zone de contact (12) étant séparées l'une de l'autre par un évidement (14).

4. Dispositif d'affichage selon la revendication 1, dans lequel le support commun (9) est une carte de circuit imprimé mécaniquement stable (15).

5. Dispositif d'affichage selon la revendication 4, dans lequel la carte de circuit imprimé stable (15) présente une ouverture (16) dont le côté opposé à l'élément de répartition de chaleur (4) comporte le capteur de lumière (7).

6. Dispositif d'affichage selon la revendication 4 ou la revendication 5, dans lequel le dispositif d'affichage comprend un élément conducteur de chaleur, et le capteur de température (6) est couplé thermiquement à l'élément de répartition de chaleur (4) au moyen de l'élément conducteur de chaleur (17).

7. Dispositif d'affichage selon l'une quelconque des revendications précédentes, dans lequel le dispositif d'affichage présente en outre un élément de liaison (18, 18'), au moyen duquel la carte de circuit imprimé (15) est disposée sur l'élément de répartition de chaleur (4).

8. Dispositif d'affichage selon la revendication 7, dans lequel l'élément de liaison (18, 18') est un élément de rembourrage.

9. Dispositif d'affichage selon la revendication 7 ou 8, dans lequel l'élément de liaison (18) présente au moins un évidement (26, 27) qui se trouve dans la zone d'au moins l'un du capteur de température (6) et du capteur de lumière (7).
